(19) Europäisches Patentamt
European Patent Office
Office européen des brevets

(11) Publication number: **0 162 572 B1**

(12) **EUROPEAN PATENT SPECIFICATION**

(45) Date of publication of patent specification: 25.01.89

(51) Int. Cl.[4]: C 08 F 2/50, G 03 F 7/10

(21) Application number: 85302652.4

(22) Date of filing: 16.04.85

**ERRATUM**

| DIE TEXTSTELLE: / TEXT PUBLISHED: / LE PASSAGE SUIVANT: | (SEITE, SPALTE, ZEILE) (PAGE, COLUMN, LINE) (PAGE, COLONNE, LIGNE) | | LAUTET BERICHTIGT: / SHOULD READ: / DEVRAIT ETRE LU: |
|---|---|---|---|
| applications | 3 | 10 | application |
| those references | 3 | 11/12 | that reference |
| Example 6-7 | 3 | 20 | Examples 6-7 |
| z-allylcyclohexanone | 3 | 23 | 2-allylcyclohexanone |
| Example 8 and 9 | 3 | 23 | Examples 8 and 9 |
| The mixed warm reflex over $\frac{1}{2}$ hour | 3 | 46/47 | The mixture was refluxed over a $\frac{1}{2}$ hour |
| product example | 4 | 5/6 | product of example |
| $H_2C$ | 4 | 18 | $H_2O$ |
| 78°C | 4 | 50 | -78°C |
| 15.4 | 4 | 52 | 15.4g |

Tag der Entscheidung über die Berichtigung / Date of decision on rectification: / Date de décision portant sur modification: 14.12.88

Ausgabe- und Veröffentlichungstag: / Issue and publication date: / Date d'edition et de publication: 29.3.89

Patbl.Nr: / EPB no: 89/13 / Bull. no:

(19) Europäisches Patentamt
European Patent Office
Office européen des brevets

(11) Publication number: 0 162 572 B1

(12) **EUROPEAN PATENT SPECIFICATION**

(45) Date of publication of patent specification: 25.01.89

(51) Int. Cl.⁴: C 08 F 2/50, G 03 F 7/10

(21) Application number: 85302652.4

(22) Date of filing: 16.04.85

(54) **Siloxane polyphotoinitiators of the substituted acetophenone type.**

(30) Priority: 19.04.84 US 601881
16.04.84 US 600628

(43) Date of publication of application:
27.11.85 Bulletin 85/48

(45) Publication of the grant of the patent:
25.01.89 Bulletin 89/04

(84) Designated Contracting States:
DE FR GB

(56) References cited:
US-A-3 715 293
US-A-4 391 963

(73) Proprietor: LOCTITE CORPORATION
705 North Mountain Road
Newington, Connecticut 06111 (US)

(72) Inventor: Lin, Samuel Q. S.
415, Central Boulevard
Fort Lee New Jersey 07024 (US)
Inventor: Jacobine, Anthony F.
310, North Wall Street
Meriden Connecticut 06450 (US)
Inventor: Fabrizio, Louis F.
150, Tomlinson Avenue
Plainville Connecticut 06062 (US)

(74) Representative: Marchant, James Ian et al
Elkington and Fife High Holborn House 52/54
High Holborn
London WC1V 6SH (GB)

EP 0 162 572 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

Many photoinitiators have been developed which are soluble in, and effectively cure, unsaturated organic resins. However, it has been found that such photoinitiators often have limited solubility, and therefore reduced curing effectiveness, in silicones. To overcome this compatibility problem, it has been proposed to bond chemically certain photoinitiating moieties to silicones.

A Japanese patent publication, Kokai no. 34,291/76 decribes the use of benzephenone derivatives, such as 4-dimethylamino-4'-(trimethoxysilyl)-benzophenone, in preparing silicone compatible photoinitiators.

Another Japanese patent publication, Kokai No. 71,199/78, describes the preparation of photoinitiators from the reaction of alkenylsilylbenzophenone and silicones containing silicon hydrides.

Japanese patent publication Kokai No. 50,067/79 and U.S. Patent 4,273,907, describe benzoin type photoinitiators attached to the ends of polydimethylsiloxane through an Si—O—C bond. However, the Si—O—C bond is well known to be hydrolytically unstable.

In U.S. Patent 4,391,963 there are described silicones having benzoin photomoieties bonded thereto through Si—C bonds. These materials are prepared by hydrosilation of alkenyl substituted benzoins.

In EP—A 0,088,842 there are described silicon bonded benzophenone polyphotoinitiators prepared by hydrosilation of an alkenyloxy-substituted benzophenone.

The present invention relates to novel photoinitiating silicones in which a photomoiety of the substituted acetophenone type is bound to a silicon atom by a Si—C bond. The new photosensitive silicones are conveniently prepared by hydrosilation of corresponding acetophenones having olefinic or acetylenic unsaturation.

More particularly, the present invention provides an organopolysiloxane photoinitiator having an average of at least two siloxane units, of which at least an average of one siloxane unit per organopolysiloxane molecule has the formula:

$$X_aR_bSiO_{(4-a-b)/2} \qquad (I)$$

wherein a is an integer of from 1 to 3, b is an integer of from 0 to 2 and a plus b equals 1 to 3; R is $C_1$—$C_{10}$ hydrocarbyl or halogen substituted $C_1$—$C_{10}$ hydrocarbyl; and X is a substituted acetophenone photomoiety selected from:

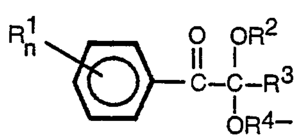
(II)

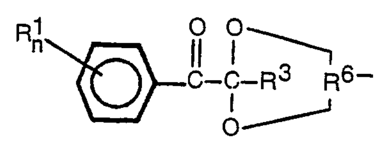
(IIa)

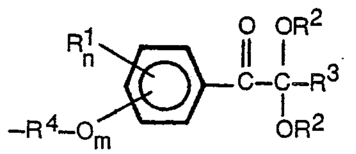
(III)

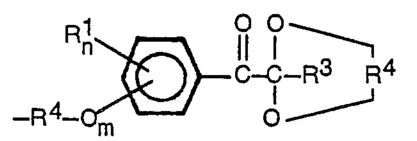
(IIIa).

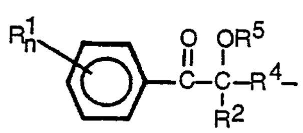
(IV)

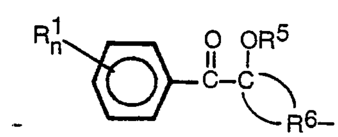
(IVa)

wherein $R^1$ is halo, alkyl, alkoxy or allyloxymethyl n is an integer from 0 to 5 in formulas (IIa), (IV) and (IVa) from 0 to 4 in formulas (III); and (IIIa); m is 0 or 1; $R^2$ is alkyl or substituted alkyl; $R^3$ is H, alkyl or aryl; $R^4$ is a divalent hydrocarbon group having from 2 to 10 carbon atoms; or an alkyleneoxyalkylene group; $R^5$ is H or a group selected from alkyl, aryl, organosilyl, or the reaction product of an isocyanate, esterifying reagent or etherification reagent with the hydroxyl product formed when $R^5$ is H and $R^6$ is trivalent hydrocarbon or hydrocarbonoxyhydrocarbon group.

Suitable R groups in the above formula include alkyl groups such as methyl and ethyl, halogen substituted alkyl groups such as trifluoropropyl and aryl groups such as phenyl.

The $R^2$ groups may be linear, branched or cyclic alkyl or substituted alkyl groups, including methyl, ethyl, cyclohexyl cyclooctyl, trichloroethyl, trifluoropropyl and organosilylalkyl such as (trimethylsiloxy) dimethylsilypropyl and trimethylsilylpropyl. In general the $R^2$ alkyl groups may be substituted with any radical which will not interfere with hydrosilation or the photoinitiating ability of the photomoiety.

It should be understood that combined cyclic structures are encompassed within the invention. Thus, cyclic acetal or ketal structures may be formed by a carbon-to-carbon linkage of $R^2$ and $R^4$ in formula (II) or the $R^2$ groups in formula (III). Cycloaliphatic structures may be formed by a carbon-to-carbon linkage of $R^2$ and $R^4$ in formula (IV). The resulting structures are represented by the formulas (IIa), (IIIa) and (IVa) respectively.

As will be readily apparent to those skilled in the art, both the open and the cyclic structures can be readily prepared by the synthetic methods taught herein.

The present invention also provides a composition comprising a photoinitiator as defined above and a free radical curable compound. The invention further provides a method of curing a free radical curable compound which method comprises subjecting a composition of the said compound and a photoinitiator as defined above to actinic radiation. Preferably the curable compound is a silicone such as an acrylic or vinyl functional silicone.

The hydrosilation techniques useful for producing the inventive polyphotoinitiators are analogous to those described in the aforementioned U.S. Patent 4,391,963. Those procedures may be followed exactly except that the unsaturated benzoic or other photomoieties described in such applications are replaced on a mole-for-mole basis by the unsaturated photomoieties described below. As described in those references, SiH functional silicones may be used to directly hydrosilate the unsaturated photomoiety. Alternatively, SiH functional silanes having polymerizable functionality such as chloro or alkoxy, may be used followed by condensation of the resulting photoinitiating silane with other silanes or silicones.

Unsaturated acetophenones suitable as intermediates in the production of inventive polyphotoinitiators can be synthesized by a variety of means including (a) reaction of an alkenyl or alkynyl halide and an alkali alkoxide with an α-oxo-arylacetophenone (e.g. benzil) or an analogous α-oxoalkylacetophenone, as exemplified in example 5 of U.S. Patent 4,287,367; (b) transacetalization of an α,α-dialkoxyacetophenone with an unsaturated alcohol, followed by blocking of one of the unsaturated groups as exemplified in Example 6—7; (c) oxidative nitrosation in the presence of excess alcohol of an acetophenone having an unsaturated substituent on the aromatic ring as exemplified in Example 4; or (d) reaction of a benzaldehyde cyanohydrin silylether with a ketone having unconjugated olefinic or acetylenic unsaturation (e.g. methyl allyl ketone or z-allylcyclohexanone), as exemplified in Example 8 and 9.

Other synthetic methods for obtaining the unsaturated intermediate photomoieties may occur to those skilled in the art without departing from the invention hereof which is illustrated by the following examples.

### Example 1

Benzil methyl-allyl-ketal was prepared by the procedure of Example 5 of U.S. Patent 4,287,367. 2.5 grams of this compound were mixed with 30 grams of a polydimethylsiloxane containing a calculated $4.46 \times 10^{-4}$ equivalents of Si—H per gram of polymer and a calculated molecular weight of about 15,000. The mixture was heated in a flask to 100°C. 0.2 grams of chloroplatinic acid was added, causing an exotherm to 130°C. Stirring continued at 130°C for 30 minutes. The product placed in a glass vial overnight remained clear.

### Example 2

The product of example 1 (1 gram) was mixed with 4 grams of a 12,000 molecular weight dimethylpolysiloxane terminated with acryloxypropenyl groups. The acryloxypropenyl terminated silicone is disclosed in example 4 of co-pending application serial number 575,256 filed January 30, 1984. The resulting clear solution, as a 6.35 mm (¼ inch) thick slug was exposed to UV irradiation of 70,000 microwatts per square centimeter for 20 seconds per side to produce a completely cured polymer mass.

### Example 3

Preparation of 4-allyloxymethylacetophenone

4-bromomethylacetophenone was prepared by mixing together 53.6 grams 4-methylacetophenone 78.8 grams N-bromosuccinimide, 550 ml $CCl_4$, and 0.5 grams benzoyl peroxide. The mixed warm reflex over ½ hour period and the reaction monitored via glpc and tlc until evidence of starting materials had substantially disappeared. The reaction was cooled, the cooled product isolated by evaporation of solvent and purified by distillation at 105—109° C/O 5 mm Hg.

4-allyloxymethylacetophenone was then prepared by mixing 74 grams of purified bromomethylacetophenone, 300 ml $CHCl_3$, 40 mls $H_2O$ and 170 grams allyl alcohol, followed by addition of 30 grams NaOH and 15 grams of a 40% solution of tetra-n-butyl ammonium hydroxide. The mixture exothermed to reflux and was stirred for 4 hours. The reaction was terminated by addition of 300 mls of water. The organic phase was separated, concentrated by evaporation of solvent and the product purified by distillation at 120—135°C/O. 6 mm Hg.

### Example 4

Preparation of alpha, alpha-diethoxy-4-allyloxymethyl acetophenone

The title product was prepared by mixing the product of example 3 (47.5 grams) with 350 ml ethanol and adding 10 grams HCl gas. The temperature reached about 40°C, at which point $C_2H_5ONO$ was bubbled into the reaction mixture. The nitrite addition was continued until glpc showed no further change in starting material quantities. The temperature of the mixture was then held at about 60°C for 2 hours, cooled and then drowned in a 5% sodium bicarbonate solution. The organic phase was extracted with $CH_2Cl_2$, washed with a dilute sodium hydroxide solution, concentrated by evaporation of solvent and isolated by distillation at 141—148°C/O. 5 mm Hg.

This same reaction can be used to prepare dialkoxy acetophenones from other acetophenone compounds have unsaturated aromatic substitutents such as 4-allyloxyacetophenone and 4-vinylacetophenone.

Example 5

5 grams of the silicon hydride functional silicone utilized in example 1 and 0.25 grams of the product example 4 were weighed into a 3 neck round bottom 25 ml flask equipped with magnetic stirrer and thermometer. The temperature of the cloudy mixture was brought to 100°C and 1 drop (approximately 0.1 g) of a 2% chloroplatinic acid solution in butyl acetate was added. The addition produced an exotherm and a clear solution. After 15 minutes the reaction was terminated. The resulting product remained clear on cooling and was soluble in dimethyl silicones having 2,5 and 8% methylvinyl siloxane repeat units. 20% by weight mixtures of the polyphotoinitiator product in such vinyl silicones cured when exposed to UV irradiation of 70.000 microwatts/square centimeter for two minutes.

Example 6

α,α-Diallyoxyacetophenone was prepared as follows. α,α-Diethoxyacetophenone (104 grams) and 300 ml allyl alcohol were stirred and heated with 8 grams p-toluene sulfonic acid $H_2C$. As ethyl alcohol was removed via a Dean-Stark trap another 109 mls allyl alcohol was added. The reaction was monitored by glpc until completion. The mixture was then cooled and 500 mls of saturated sodium bicarbonate solution was added. The organic fraction was separated and the aqueous fraction extracted with hexane. The organic fractions were then combined, dried, filtered and concentrated. The product was purified by distillation at 125—130°C/0.9 mm Hg.

Example 7

Into a 25 ml 3 neck round bottomed flask equipped with a thermometer and stirred were placed 1 gram of α,α-diallyloxyacetophenone and .63 grams of pentamethyldisiloxane. The flask were placed in an oil bath at 85°C. When the temperature reached 85°C, 0.5 grams of a 2% chloroplatinic acid solution were added. After stirring for 5 minutes, 2.2 grams of an approximately 1,000 molecular weight dimethylsilicone terminated with silicon hydride (0.002eg.H/gram) were added along with an additional 0.05 grams of chloroplatinic acid solution. An exotherm from 110°C to 125°C was observed. After about 5 minutes the reaction was allowed to cool producing a dark fluid product. This product was soluble in a 70,000 molecular weight silicone containing 8% by mole methylvinylsiloxane units.

A 20% solution of the product in this vinyl silicone cured a 6.35 mm ($\frac{1}{4}$ inch) slug when exposed to UV irradiation of 70.000 microwatts per square centimeter for 2 minutes.

The solubility of this low molecular weight silicone photoinitiator in high molecular weight silicones was particularly surprising since a benzoin type photoinitiator prepared from the same 1,000 molecular weight silicone by the method of U.S. Patent 4,391,963 was not soluble in other higher molecular weight silicones.

Example 8

Benzaldehyde, 19.6 gms; trimethylsilylcyanide, 20.4 gms; and 100 ml acetonitrile were added to a round bottomed flask equipped with condensor, stirrer and argon gas inlet. Two min. after the addition, 1 g anhydrous stannous chloride was added. The reaction was exothermic. Stirring was continued for 1 hr. after which the reaction was quenched by pouring the solution into a separatory funnel containing ice water. The crude product was extracted into methylenedichloride, dried over $MgSO_4$ and $Na_2CO_3$ and subjected to vacuum distillation at 114°C and 0.28 mm Hg.

A moisture free apparatus consisting of a 500 ml 3-neck round-bottomed flask, three dropping funnels, a gas inlet tube and a stirring bar was set up and purged thoroughly with argon. 12.1 g diisopropylamine and 250 ml tetrahydrofuran were added to the flask and the resulting solution cooled to 78°C. 120 ml s-butyl lithium in hexane (1.25M) was added and the mixture stirred at −78°C for an hour. 20.5 g of the product of the previous paragraph were then added over 30 min. 15.4 of 2-allylcyclohexane was then added and the solution maintained at −78°C for 1 hour. After the mixture had reached room temperature, 10 ml $H_2O$ was added. The mixture was then poured into a liter of water and extracted with benzene. The benzene layer was dried over $MgSO_4$ evaporated to give the trimethylsilyl ether of 1-benzoyl-2-allylcyclohexanol.

15 grams of the silcone hydride functional dimethyl silicone used in example 2 were reacted as in example 2 with 1.4 grams of the trimethylsilyl ether of 1-benzoyl-2-allylcyclohexanol. 0.3 grams of the resulting product was then dissolved in 3 grams of a silicone containing 85 methylvinylcyclohoexanone units. A thin film of this mixture was exposed to UV irradiation of 70,000 microwatts per square centimeter for 2 minutes producing a cured clear film.

Example 9

Example 8 may be repeated substituting an equivalent amount of methyl allyl ketone for the 2-allylcyclohexanone utilized in that example. After the hydrosilation, the resulting polyphotoinitiator product will be represented by formula (1) where X is:

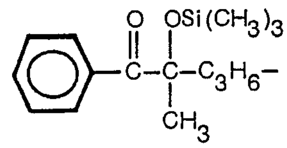

(V)

Example 10

If Example 6 is repeated substituting an excess of a monoallyl ether of glycerin for the allyl alcohol in Example 6, a cyclic unsaturated acetal product is formed which may subsequently be hydrosilated as in Example 7 to give a polyphotoinitiator product of the invention. The 1-allyl ether of glycerin may thus be utilized to produce a photoinitiator of the invention where X in formula (I) above is

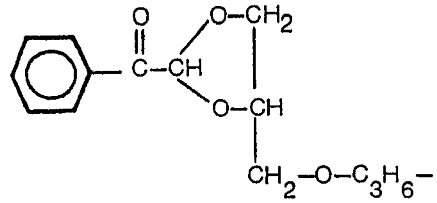

(VI)

The 2-allyl ether of glycerin can thus be utilized to give a photoinitiator of the invention where X is

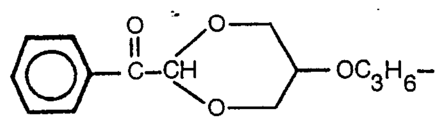

(VII)

Among the many variations of the above procedures which can be employed without departing from the invention hereof are the use of mixed saturated and unsaturated alcohols in the procedure of Example 6; substitution of acetylenic reagents for the corresponding olefinic reagents (e.g., propargyl bromide or alcohol for allyl bromide or alcohol in Examples 1, 3 and 6); blocking of one of the unsaturated groups of the diallyl product of Example 6 with other olefinically reactive reagents such as trimethylsilane, hydrogen or halogens; and acid catalyzed cleavage of the trimethylsilyl ether product of Example 8 to the corresponding alcohol, with optional subsequent esterification, etherification or reaction with other hydroxy reactive materials such as isocyanates or epoxides.

While the primary use of the inventive compounds is in the photocuring of vinyl or acrylic (i.e. acrylate, methacrylate, etc.) functional silicones, other compounds with free radical curable functionality such as organic compounds with vinyl, acrylic, maleic, or itaconic functionalities may also be photocured with the inventive compounds as well.

## Claims

1. An organopolysiloxane photoinitiator having an average of at least two siloxane units, of which at least an average of one siloxane unit per organopolysiloxane molecule has the formula:

$$X_aR_bSiO_{(4-a-b)/2} \qquad (I)$$

wherein a is an integer of from 1 to 3, b is an integer of from 0 to 2 and a plus b equals 1 to 3; R is $C_1$—$C_{10}$ hydrocarbyl or halogen substituted $C_1$—$C_{10}$ hydrocarbyl; and X is a substituted acetophenone photomoiety selected from:

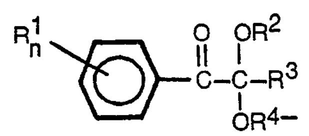

(II)

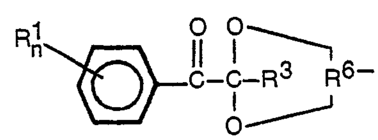

(IIa)

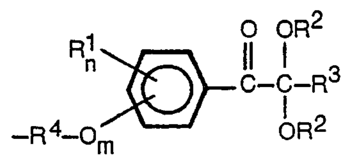

(III)

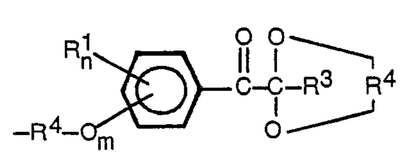

(IIIa)

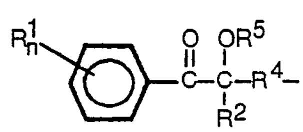

(IV)

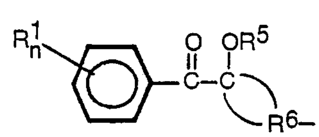

(IVa)

where $R^1$ is halo, alkyl, alkoxy or allyloxymethyl; n is an integer from 0 to 5 in formulas (II), (IIa), (IV) and (IVa) from 0 to 4 in formulas (III) and (IIIa); m is 0 or 1; $R^2$ is alkyl or substituted alkyl; $R^3$ is H, alkyl or aryl; $R^4$ is a divalent hydrocarbon group having from 2 to 10 carbon atoms; or an alkyleneoxyalkylene group; $R^5$ is H or a group selected from alkyl, aryl, organosilyl, or the reaction product of an isocyanate, esterification reagent or an etherification reagent with the hydroxyl product formed when $R^5$ is H and $R^6$ is trivalent hydrocarbon or hydrocarbonoxyhydrocarbon group.

2. A photoinitiator as claimed in Claim 1, wherein R is alkyl, substituted alkyl or aryl.

3. A photoinitiator as claimed in Claim 1, or 2 wherein n is 0.

4. A photoinitiator as claimed in any of Claims 1 to 3 where X is selected from formulas II and III and $R^2$ is alkyl.

5. A photoinitiator as claimed in any of Claims 1 to 3 wherein X has the structure of formula IIa.

6. A photoinitiator as claimed in any of claims 1 to 3 wherein X has the structure of formula III and m is 1.

7. A photoinitiator as claimed in any of Claims 1 to 3 wherein X has the structure of formula IVa.

8. A photoinitiator as claimed in any of Claims 1 to 3 wherein X has the structure of formula IV and $R^5$ is organisilyl.

9. A photoinitiator as claimed in any of claims 1 to 3, 4, 6, or 8 where $R^4$ is propylene or propenylene.

10. A photoinitiator as claimed in any of claims 1 to 3, 6, 8 or 9 in which $R^2$ is an alkyl or alkenyl group substituted with an organosilyl group.

11. A photoinitiator as claimed in Claim 10 where $R^2$ is trimethylsilylpropyl or (trimethylsiloxy) dimethylsilylpropyl.

12. A composition comprising a photoinitiator as claimed in any of Claims 1 to 11 and a free radical curable compound.

13. A composition as claimed in Claim 12 wherein the curable compound is a silicone.

14. A composition as claimed in Claim 13 wherein the silicone is an acrylic or vinyl functional silicone.

15. A method of curing a free radical curable compound which method comprises subjecting composition of the said compound and a photoinitiator as claimed in any of claims 1 to 11 to actinic radiation.

16. A method as claimed in Claim 15 wherein the curable compound is a silicone.

17. A method as claimed in Claim 16 wherein the silicone is an acrylic of vinyl functional silicone.

**Patentansprüche**

1. Organopolysiloxan-Photoinitiator mit einem Durchschnitt von wenigstens zwei Siloxaneinheiten, von welchen wenigstens im Durchschnitt eine Siloxaneinheit pro Organopolysiloxanmolekül die Formel aufweist:

$$X_aR_bSiO_{(4-a-b)/2} \qquad (I)$$

worin a eine ganze Zahl von 1 bis 3 ist, b eine ganze Zahl von 0 bis 2 ist und a plus b gleich 1 bis 3 ist; R ein $C_1$—$C_{10}$-Kohlenwasserstoff oder ein halogensubstituierter $C_1$—$C_{10}$-Kohlenwasserstoff ist; und X eine substituierte Acetophenon-Photoeinheit ist, ausgewählt aus:

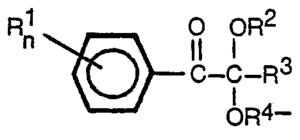 (II)

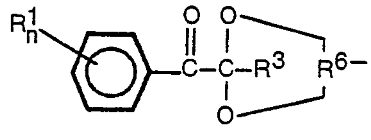 (IIa)

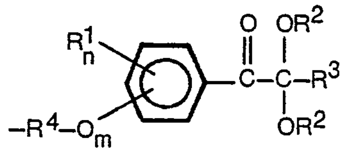 (III)

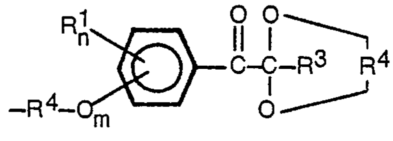 (IIIa)

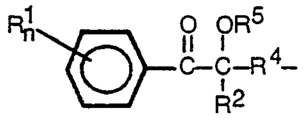 (IV)

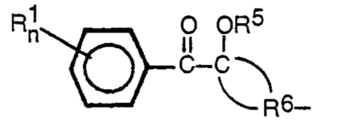 (IVa)

worin $R^1$ Halogen, Alkyl, Alkoxy oder Allyloxymethyl ist; n eine ganze Zahl von 0 bis 5 in den Formeln (II), (IIa), (IV) und (IVa) und von 0 bis 4 in den Formeln (III) und (IIIa) ist; m 0 oder 1 ist; $R^2$ Alkyl oder substituiertes Alkyl ist; $R^3$ H, Alkyl oder Aryl ist; $R^4$ eine zweiwertige Kohlenwasserstoffgruppe mit 2 bis 10 Kohlenstoffatomen oder eine Alkylenoxyalkylengruppe ist; $R^5$ H ist oder eine Gruppe, ausgewählt aus Alkyl, Aryl, Organosilyl oder dem Reaktionsprodukt eines Isocyanat-Veresterungsreagens oder eines Veretherungsreagens mit dem Hydroxylprodukt, das gebildet wird, wenn $R^5$ H ist; und $R^6$ eine trivalente

Kohlenwasserstoff- oder Kohlenwasserstoffoxykohlenwasserstoffgruppe ist.

2. Photoinitiator, wie in Anspruch 1, beansprucht, worin R Alkyl, substituiertes Alkyl oder Aryl ist.

3. Photoinitiator, wie in Anspruch 1 oder 2 beansprucht, worin n 0 ist.

4. Photoinitiator, wie in einem der Ansprüche 1 bis 3 beansprucht, worin X aus den Formeln II und III ausgewählt wird und $R^2$ Alkyl ist.

5. Photoinitiator, wie in einem der Ansprüche 1 bis 3 beansprucht, worin X die Struktur der Formel IIa hat.

6. Photoinitiator, wie in einem der Ansprüche 1 bis 3 beansprucht, worin X die Struktur der Formel III hat und m 1 ist.

7. Photoinitiator, wie in einem der Ansprüche 1 bis 3 beansprucht, worin X die Struktur der Formel IVa hat.

8. Photoinitiator, wie in einem der Ansprüche 1 bis 3 beansprucht, worin X die Struktur der Formel IV hat und $R^5$ Organosilyl ist.

9. Photoinitiator, wie in einem der Ansprüche 1 bis 3, 4, 6 oder 8 beansprucht, worin $R^4$ Propylen oder Propenylen ist.

10. Photoinitiator, wie in einem der Ansprüche 1 bis 3, 6, 8 oder 9 beansprucht, worin $R^2$ eine mit einer Organosilylgruppe substituierte Alkyl- oder Alkenylgruppe ist.

11. Photoinitiator, wie in Anspruch 10 beansprucht, worin $R^2$ Trimethylsilylpropyl oder (Trimethylsiloxy)dimethylsilylpropyl ist.

12. Zusammensetzung, welche einen Photoinitiator, wie in einem der Ansprüche 1 bis 11 beansprucht, und eine mit freien Radikalen härtbare Verbindung umfaßt.

13. Zusammensetzung, wie in Anspruch 12 beansprucht, worin die härtbare Verbindung eine Silikon ist.

14. Zusammensetzung, wie in Anspruch 13 beansprucht, worin das Silkon ein acryl- oder vinylfunktionelles Silikon ist.

15. Verfahren zur Härtung einer mit freien Radikalen härtbaren Verbindung, welches Verfahren das Aussetzen einer Zusammensetzung aus dieser Verbindung und einem Photoinitiator, wie in einem der Ansprüche 1 bis 11 beansprucht, an eine aktinische Strahlung umfaßt.

16. Verfahren, wie in Anspruch 15 beansprucht, worin die härtbare Verbindung ein Silikon ist.

17. Verfahren, wie in Anspruch 16 beansprucht, worin das Silikon ein acryl- oder vinylfunktionelles Silikon ist.

**Revendications**

1. Un photoinitiateur organopolysiloxane comportant une moyenne d'au moins deux motifs siloxanes, dont au moins une moyenne d'un motif siloxane par molécule d'organopoilysiloxane répond à la formule:

$$X_aR_bSiO_{(4-a-b)/2} \qquad (I)$$

dans laquelle a est un entier de 1 à 3, b est un entier de 0 à 2 et a plus b vaut de 1 à 3; R est un groupe hydrocarbyle en $C_1$ à $C_{10}$ ou un groupe hydrocarbyle en $C_1$ à $C_{10}$ halogéno-substitué; et X est un radical photoréactif d'acétophénone substituée choisi parmi

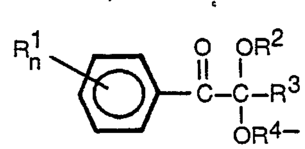 (II)

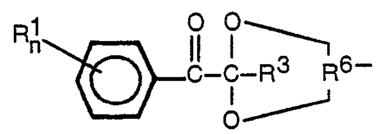 (IIa)

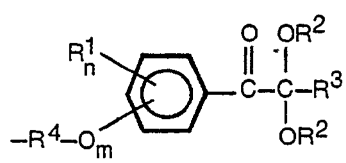 (III)

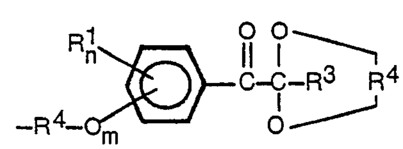 (IIIa)

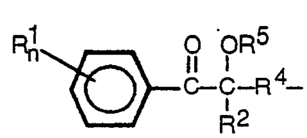 (IV)

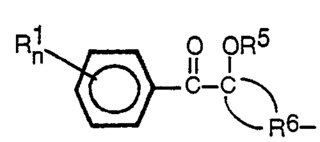 (IVa)

où $R^1$ est un groupe halogéno, alkyle, alcoxy ou allyloxyméthyle; n est un entier valant de 0 à 5 dans les formules (II), (IIa), (IV) et (IVa) et de 0 à 4 dans les formules (III) et (IIIa); m vaut 0 ou 1; $R^2$ est un groupe alkyle ou alkyle substitué; $R^3$ est un atome d'hydrogène ou un groupe alkyle ou aryle; $R^4$ est un groupe hydrocarboné divalent comportant de 2 à 10 atomes de carbone ou un groupe alkylènoxyalkylène; $R^5$ est un atome d'hydrogène ou un groupe choisi parmi les groupes alkyles, aryles, organosilyles, ou le produit

de réaction d'un réactif d'estérification isocyanate ou d'un réactif d'éthérification avec le produit hydroxylé formé lorsque $R^5$ est un atome d'hydrogène; et $R^6$ est un groupe hydrocarboné ou hydrocarbonoxy-hydrocarboné trivalent.

2. Un photoinitiateur tel que revendiqué dans la revendication 1, dans lequel R est un groupe alkyle, alkyle substitué ou aryle.

3. Un photoinitiateur tel que revendiqué dans la revendication 1 ou 2, dans lequel n vaut zéro.

4. Un photoinitiateur tel que revendiqué dans l'une quelconque des revendications 1 à 3, où X est choisi parmi les formules II et III et $R^2$ est un groupe alkyle.

5. Un photoinitiateur tel que revendiqué dans l'une quelconque des revendications 1 à 3, dans lequel X répond à la structure de la formule IIa.

6. Un photoinitiateur tel que revendiqué dans l'une quelconque des revendications 1 à 3, dans lequel X répond à la structure de la formule III et m vaut 1.

7. Un photoinitiateur tel que revendiqué dans l'une quelconque des revendications 1 à 3, dans lequel X répond à la structure de la formule IVa.

8. Un photoinitiateur tel que revendiqué dans l'une quelconque des revendications 1 à 3, dans lequel X répond à la structure de la formule IV et $R^5$ est un groupe organosilyle.

9. Un photoinitiateur tel que revendiqué dans l'une quelconque des revendications 1 à 3, 4, 6 ou 8, dans lequel $R^4$ est un groupe propylène ou propénylène.

10. Un photoinitiateur tel que revendiqué dans l'une quelconque des revendications 1 à 3, 6, 8 ou 9, dans lequel $R^2$ est un groupe alkyle ou alkényle substitué par un groupe organosilyle.

11. Un photoinitiateur tel que revendiqué dans la revendication 10, où $R^2$ est un groupe triméthylsilylpropyle ou (triméthylsiloxy) diméthylsilylpropyle.

12. Une composition comprenant un photoinitiateur tel que revendiqué dans l'une quelconque des revendications 1 à 11 et un composé durcissable par des radicaux libres.

13. Une composition telle que revendiquée dans la revendication 12, dans laquelle le composé durcissable est une silicone.

14. Une composition telle que revendiquée dans la revendication 13, dans laquelle la silicone est une silicone à fonctionnalité acrylique ou vinylique.

15. Un procédé de durcissement d'un composé durcissable par radicaux libres, lequel procédé comprend la soumission de la composition dudit composé et d'un photoinitiateur tel que revendiqué dans l'une quelconque des revendications 1 à 11 à un rayonnement actinique.

16. Un procédé tel que revendique dans la revendication 15, dans lequel le composé durcissable est une silicone.

17. Un procédé tel que revendiqué dans la revendication 16, dans lequel la silicone est une silicone à fonctionnalité acrylique ou vinylique.